# EUROPÄISCHE PATENTSCHRIFT

(11) **EP 1 317 797 B1**
(45) Veröffentlichungstag und Bekanntmachung des Hinweises auf die Patenterteilung: **15.11.2006**
(21) Anmeldenummer: 01976209.5
(22) Anmeldetag: 10.09.2001
(51) Int. Cl.: H03H 9/17

(54) **AKUSTISCHER RESONATOR**
ACOUSTIC RESONATOR
RESONATEUR ACOUSTIQUE

(30) Priorität: 12.09.2000 DE 10045090
(43) Veröffentlichungstag der Anmeldung: 11.06.2003
(73) Patentinhaber: Infineon Technologies AG, 81669 München (DE)
(72) Erfinder: AIGNER, Robert, 81675 München (DE); ELBRECHT, Lueder, 80805 Muenchen (DE); MARKSTEINER, Stephan, 85640 Putzbrunn (DE); NESSLER, Winfried, 81739 München (DE); TIMME, Hans-Joerg, 85521 Ottobrunn (DE)
(74) Vertreter: Ginzel, Christian
(86) Internationale Anmeldenummer: PCT/EP2001/010435
(87) Internationale Veröffentlichungsnummer: WO 2002/023720

(56) Entgegenhaltungen:
- US-A- 4 456 850
- US-A- 5 873 154

## Beschreibung

Die Erfindung betrifft einen akustischen Resonator, d.h. ein Bauelement, das akustische Wellen und elektrische Spannungsänderungen ineinander umwandelt.

Ein solcher Resonator weist üblicherweise eine Schichtenfolge bestehend aus zwei Elektroden und einer dazwischen angeordneten piezoelektrischen Schicht auf. Ein Bulk-Acoustic-Wave Resonator besteht beispielsweise aus einer solchen Schichtenfolge, die auf einer Membran oder einem akustischen Spiegel angeordnet ist (siehe z.B. US 5,873,154). Im Bereich der sogenannten Serien- und Parallelresonanz bilden sich stehende vertikale Wellen aus, wobei sich etwa eine halbe Welle entlang der gesamten Dicke der Schichtenfolge ausbreitet.

Die piezoelektrische Schicht besteht in der Regel aus einem Material, wie z.B. AlN, das prozeßtechnisch schwer abscheidbar ist. Um Abscheidezeiten zu reduzieren, werden Resonatoren mit einer möglichst dünnen piezoelektrischen Schicht angestrebt.

Eine dünne piezoelektrische Schicht ist auch aus dem Grunde vorzuziehen, daß der Flächenbedarf des Resonators bei gleichbleibendem Impendanzniveau mit dünner werdender piezoelektrischer Schicht abnimmt, so daß ein Resonator mit dünner piezoelektrischer Schicht einen geringen Platzbedarf aufweist. Resonatoren sollten ein bestimmtes Impendanzniveau haben, um im Durchlaßbereich der Filterkennlinie eine geringe Einfügedämpfung zu gewährleisten.

Da die Resonanzfrequenz eines Resonators durch die Dicke aller beteiligten Schichten der Schichtenfolge bestimmt wird, d.h. nicht nur durch die Dicke der aktiven piezoelektrischen Schicht, sondern auch durch die Dicke der Elektroden, ist es möglich, die Dicke der piezoelektrischen Schicht bei vorgegebener Resonanzfrequenz zu reduzieren, indem die Dicken der Elektroden erhöht werden. Wie stark sich eine Schichtdikkenänderung auf die Resonanzfrequenz auswirkt, hängt von den akustischen Parametern der Elektrode ab. Schwere und harte Materialien bewirken eine stärkere Frequenzabsenkung bei Schiclitdickenerhöhung als leichtere und weichere Materialien.

Es ist üblich, die Elektroden aus Aluminium zu erzeugen, da Aluminium CMOS-kompatibel ist, und somit der Resonator einfach herstellbar ist. Ferner weist Aluminium eine hohe elektrische Leitfähigkeit auf. Allerdings sind die akustischen Eigenschaften von Aluminium weniger vorteilhaft.

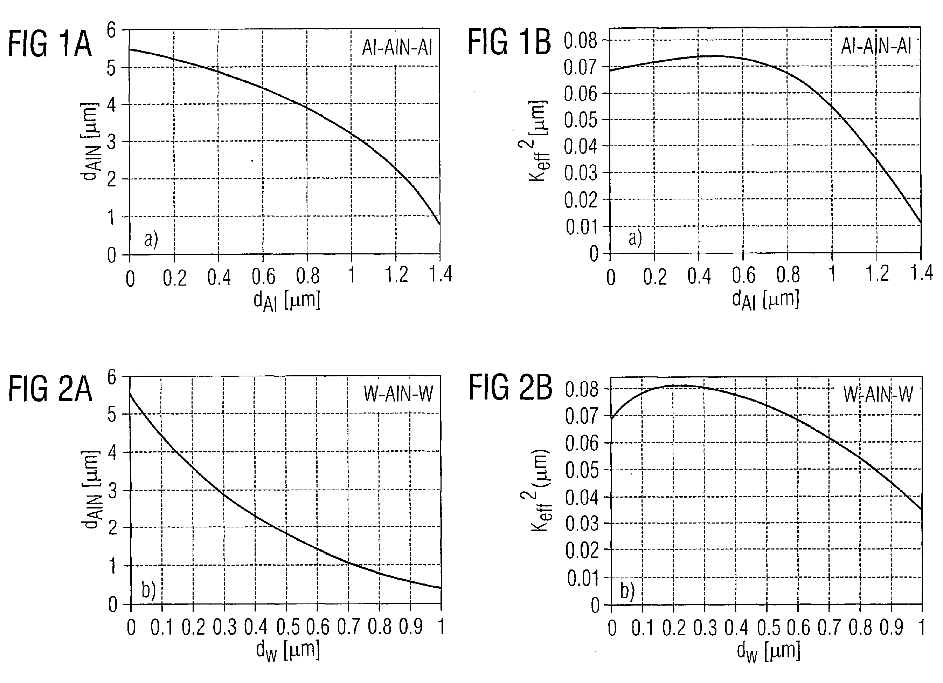

Diese Eigenschaften wurden im Vorfeld der Erfindung von den Erfindern untersucht. Einige daraus resultierende Ergebnisse werden im folgenden näher erläutert: Bei einer Resonanzfrequenz von beispielsweise 900MHz müßte die Dicke der piezoelektrischen Schicht ohne Elektroden etwa 5,5µm betragen. Durch Vorsehen von Elektroden kann diese Schichtdicke bei gleichbleibender Resonanzfrequenz reduziert werden. Figur 1a zeigt die Abhängigkeit der Dicke der piezoelektrischen Schicht von der Dicke der Aluminiumelektroden bei der obengenannten Resonanzfrequenz. Um eine Reduktion der Dicke der piezoelektrischen Schicht von 5,5*µ*m auf 3µm zu erzielen, sind ca. 1,05µm dicke Aluminiumelektroden erforderlich. Es hat sich gezeigt, daß bei solch dicken Elektroden die akustischen Eigenschaften des Resonators mangelhaft sind, da der effektive Koppelkoeffizient bei großen Dicken der Aluminiumelektroden sehr klein ist. Der Koppelkoeffizient zum Quadrat ist definiert als K_{eff}² = pi^2*(fp/fs-1)/4 wobei fs die Serien- und fp die Parallel-Resonanzfrequenz bezeichnet. Figur 1b zeigt die Abhängigkeit des Koppelkoeffizienten zum Quadrat von der Dicke der Aluminiumelektroden, wobei die piezoelektrische Schicht aus AlN besteht. Möchte man also die Dicke der piezoelektrischen Schicht auf 3µm bei einer Resonanzfrequenz von 900MHz verringern, so muß man eine erhebliche Absenkung des Quadrats des Koppelkoeffizienten unter 0,05 in Kauf nehmen, was für Anwendungen, z.B. im GSM-Band, nicht akzeptabel ist.

Es ist bereits vorgeschlagen worden, als Material für die Elektroden Wolfram einzusetzen (siehe z.B. US 5,587,620). Untersuchungen im Vorfeld der Erfindung haben folgendes ergeben: Figur 2a zeigt die Abhängigkeit der Dicke der piezoelektrischen Schicht von der Dicke von Wolframelektroden bei einer Resonanzfrequenz von 900MHz. Beim Vergleich mit Figur 1a zeigt sich, daß eine Kompensation der Dickenreduktion der piezoelektrischen Schicht von 5,5µm auf 3µm mit wesentlich dünneren - nämlich ca. 300nm dicken - Elektroden erzielbar ist, wenn als Elektrodenmaterial Wolfram statt Aluminium verwendet wird. Der Grund dafür liegt in der höheren akustischen Impedanz von Wolfram. Figur 2b zeigt die Abhängigkeit des Koppelkoeffizienten zum Quadrat von der Dicke der Wolframelektroden, wobei die piezoelektrische Schicht aus AlN besteht. Bei 300nm dicken Elektroden ist der Koppelkoeffizient sehr hoch, so daß der Resonator sehr gute akustische Eigenschaften aufweist.

Im Gegensatz zu den Aluminiumelektroden weisen diese Wolframelektroden jedoch den Nachteil auf, daß der zugehörige Resonator schlechte elektrische Eigenschaften besitzt, so daß die Einfügedämpfung zu hoch ist. Der Grund dafür liegt darin, daß 300nm dicke Wolframelektroden einen zu hohen elektrischen Widerstand aufweisen.

Zum Schutz der piezoelektrischen Schicht bei der Herstellung eines akustischen Resonators wird in der US 5,760,663 vorgeschlagen, eine Pufferschicht aus Siliziumnitrid zwischen der piezoelektrischen Schicht und den Elektroden vorzusehen.

Die JP 02-309708 beschreibt einen akustischen Resonator, bei dem eine piezoelektrische Schicht zwischen zwei Goldelektroden angeordnet ist. Eine Dünnschicht aus Titan wird als Haftvermittler zwischen den Goldelektroden und zugeordneten Leiterbahnen verwendet.

Der Erfindung liegt die Aufgabe zugrunde, einen akustischen Resonator anzugeben, der im Vergleich zum Stand der Technik eine piezoelektrische Schicht mit geringer Dicke und zugleich gute akustische und elektrische Eigenschaften aufweist.

Die Aufgabe wird gelöst durch einen akustischen Resonator nach Anspruch 1.

Der Resonator weist also eine Schichtenfolge auf, die mindestens aus der ersten Elektrode, der ersten Verdichtungsschicht, der piezoelektrischen Schicht und der zweiten Elektrode besteht. Bei Resonanz verläuft eine halbe Welle entlang der gesamten Dicke der Schichtenfolge.

Der Erfindung liegen die oben beschriebenen Ergebnisse der Untersuchungen und die Erkenntnis zugrunde, daß die Auswirkung der Schichtdickenänderung einer Schicht der Schichtenfolge auf die Resonanzfrequenz nicht nur von den akustischen Parametern der betroffenen Schicht abhängt, sondern auch von der Lage der betroffenen Schicht zur piezoelektrischen Schicht. Schichten, die nahe an der piezoelektrischen Schicht liegen, wirken stärker als Schichten, die weiter entfernt liegen.

Durch das Vorsehen der ersten Verdichtungsschicht wird die Dicke der piezoelektrischen Schicht bei gleichbleibender Resonanzfrequenz reduziert. Das Material der ersten Verdichtungsschicht kann so gewählt werden, daß bereits eine dünne erste Verdichtungsschicht ausreicht, um die Dicke der piezoelektrischen Schicht stark zu reduzieren. Dadurch bleibt der Koppelkoeffizient hoch, so daß der Resonator gute akustische Eigenschaften aufweist.

Da die erste Elektrode weiter entfernt von der piezoelektrischen Schicht liegt als die erste Verdichtungsschicht, trägt sie nur wenig zu den akustischen Eigenschaften des Resonators bei. Das Material der ersten Elektrode kann ohne Rücksicht auf akustische Eigenschaften so gewählt werden, daß der elektrische Widerstand klein ist, so daß der Resonator gute elektrische Eigenschaften aufweist. Beispielsweise bewirken Elektroden aus Al mit Dicken von 300-600nm, die zu einem niedrigen elektrischen Widerstand führen, nur eine leichte Verschlechterung des durch Vorsehen der ersten Verdichtungsschicht erreichten Koppelkoeffizienten, und verschieben die Resonanzfrequenz unwesentlich nach unten, was durch eine zusätzliche (erwünschte) geringe Reduktion der Dicke der piezoelektrischen Schicht wiederum ausgeglichen werden kann.

Die Erfindung ermöglicht es, die akustischen und elektrischen Eigenschaften des Resonators bei beliebiger Dicke der piezoelektrischen Schicht unabhängig voneinander zu optimieren. Ferner ist es möglich, auch bei einer geringen Dicke der piezoelektrischen Schicht gute akustische und elektrische Eigenschaften des Resonators zu erzielen.

Besonders gute akustische Eigenschaften werden erzielt, wenn das Verhältnis der akustischen Impedanz der ersten Verdichtungsschicht zur akustischen Impedanz der piezoelektrischen Schicht möglichst groß ist. Vorzugsweise ist das Verhältnis der akustischen Impedanz der ersten Elektrode zur akustischen Impedanz der ersten Verdichtungsschicht möglichst klein.

Als Materialien der ersten Verdichtungsschicht mit hoher akustischer Impedanz eignen sich insbesondere W, Mo, Pt, Ta, TiW, TiN, Ir, WSi, Au, Al₂O₃, SiN, Ta₂O₅ und Zirkon-Oxid. Die letzen vier Materialien sind Dielektrika.

Bevorzugt werden leitfähige Materialien für die Verdichtungsschicht verwendet, wobei die vorstehend aufgelisteten ersten 9 Materialien besonders bevorzugt sind. Leitfähige Materialien verhindern insbesondere die Ausbildung von Serienkapazitäten, wie sie bei dielektrischen Materialien auftreten würden.

Als Materialien der piezoelektrischen Schicht eigenen sich beispielsweise AlN, ZnO, PZT, LiNbO₃.

Das Elektrodenmaterial kann so gewählt werden, daß seine Leitfähigkeit sogar ausreicht, um aus dem Elektrodenmaterial Verbindungsleitungen herzustellen. Bei der Erzeugung einer Elektrode können also gleichzeitig Verbindungsleitungen hergestellt werden. Die Elektrode kann Teil einer solchen Verbindungsleitung sein.

Das Elektrodenmaterial kann so gewählt werden, daß es für das Bonden mit Verbindungsleitungen geeignet ist. Beispielsweise dient die erste Elektrode oder die zweite Elektrode als Bondpad, auf der eine Verbindungsleitung gelötet ist.

Die Elektroden bestehen vorzugsweise im wesentlichen aus Aluminium, Titan, Silber oder Kupfer. Insbesondere Al und Cu weisen eine hohe elektrische Leitfähigkeit auf und sind darüber hinaus CMOS-kompatibel.

Zur Gewährleistung eines ausreichend geringen elektrischen Widerstands der Elektroden sind die Elektroden vorzugsweise mindestens 200 nm dick.

Besonders gute akustische und elektrische Eigenschaften des Resonators werden erzielt, wenn neben der ersten Verdichtungsschicht auch eine zweite Verdichtungsschicht vorgesehen ist, die zwischen der zweiten Elektrode und der piezoelektrischen Schicht angeordnet ist.

Der akustische Resonator kann als Bulk-Acoustic-Wave Resonator ausgestaltet sein. Die Schichtenfolge kann auf einer Membran oder einem akustischen Spiegel angeordnet sein. Dabei kann die erste Elektrode oder die zweite Elektrode an den akustischen Spiegel oder an die Membran angrenzen. Streng genommen beeinflußt auch die Membran oder der akustische Spiegel die Resonanzfrequenz. Die Beeinflussung ist jedoch gering. Eine Berücksichtigung der Membran bzw. des Spiegels bei der Optimierung der akustischen und elektrischen Eigenschaften des Resonators ist möglich, jedoch nicht erforderlich.

Erfindungsgemäß wird das Material der Verdichtungsschicht/en so gewählt daß das Verhältnis der akustischen Impedanz der Verdichtungsschicht/en zur akustischen Impedanz der piezoelektrischen Schicht größer als 2 ist.

Weiterhin ist es bevorzugt, wenn das Material der ersten Elektrode so gewählt wird, daß das Verhältnis der akustischen Impedanz der ersten Elektrode zur akustischen Impedanz der Verdichtungsschicht/en kleiner als 1/3 ist.

Im folgenden werden zwei Vergleichsbeispiele und ein Ausführungsbeispiel der Erfindung anhand der Figuren 3 bis 6 näher erläutert.
- Figur 3: zeigt einen Querschnitt durch einen ersten Resonator mit einer ersten Elektrode aus Aluminium, einer piezoelektrischen Schicht und einer zweiten Elektrode aus Aluminium. Ferner ist das Streßfeld einer akustischen Welle bei Resonanz dargestellt.
- Figur 4: zeigt einen Querschnitt durch einen zweiten Resonator mit einer ersten Elektrode aus Wolfram, einer piezoelektrischen Schicht und einer zweiten Elektrode aus Wolfram. Ferner ist das Streßfeld einer akustischen Welle bei Resonanz dargestellt.
- Figur 5: zeigt einen Querschnitt durch einen dritten Resonator mit einer ersten Elektrode aus Aluminium, einer ersten Verdichtungsschicht aus Wolfram, einer piezoelektrischen Schicht, einer zweiten Verdichtungsschicht aus Wolfram und einer zweiten Elektrode aus Aluminium. Ferner ist das Streßfeld einer akustischen Welle bei Resonanz dargestellt.
- Figur 6: zeigt einen Konturplot des effektiven Koppelkoeffizienten (durchgezogene Linien) sowie die Dicke der piezoelektrischen Schicht von analog zum dritten Resonator aufgebauten Resonatoren als Funktion der Dicke der Elektroden und der Verdichtungsschichten.

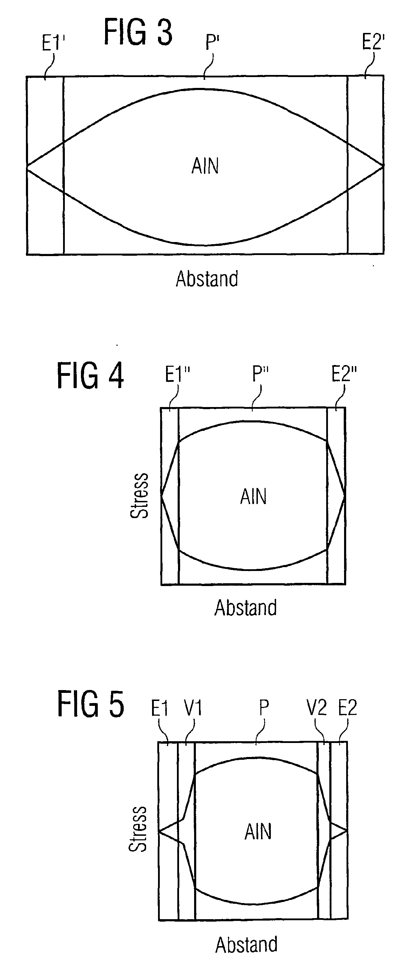

Im ersten Vergleichsbeispiel ist ein erster Resonator vorgesehen, der eine piezoelektrische Schicht P' aus AlN aufweist, die zwischen einer ersten Elektrode E1' aus Aluminium und einer zweiten Elektrode E2' aus Aluminium angeordnet ist. Das zugehörige Streßfeld bei Resonanz zeigt eine starke Variation über die piezoelektrische Schicht P' (siehe Figur 3). Da die piezoelektrische Kopplung proportional zum mittleren Streß ist, tragen Bereiche nahe der Elektroden E1', E2' weniger bei, als die Bereiche in der Mitte der piezoelektrischen Schicht P'.

Im zweiten Vergleichsbeispiel ist ein zweiter Resonator vorgesehen, der eine piezoelektrische Schicht P" aus AlN aufweist, die zwischen einer ersten Elektrode E1" aus Wolfram und einer zweiten Elektrode E2" aus Wolfram angeordnet ist. Die Streßverteilung weist einen starken Gradienten in den Elektroden E1", E2" auf und ist über die piezoelektrische Schicht P" hinweg relativ konstant (siehe Figur 4). Dies führt zu einer starken Kopplung aller Bereiche der piezoelektrischen Schicht P''. Die hohe akustische Impedanz des Wolframs "verdichtet" sozusagen die akustische Welle in der piezoelektrischen Schicht P".

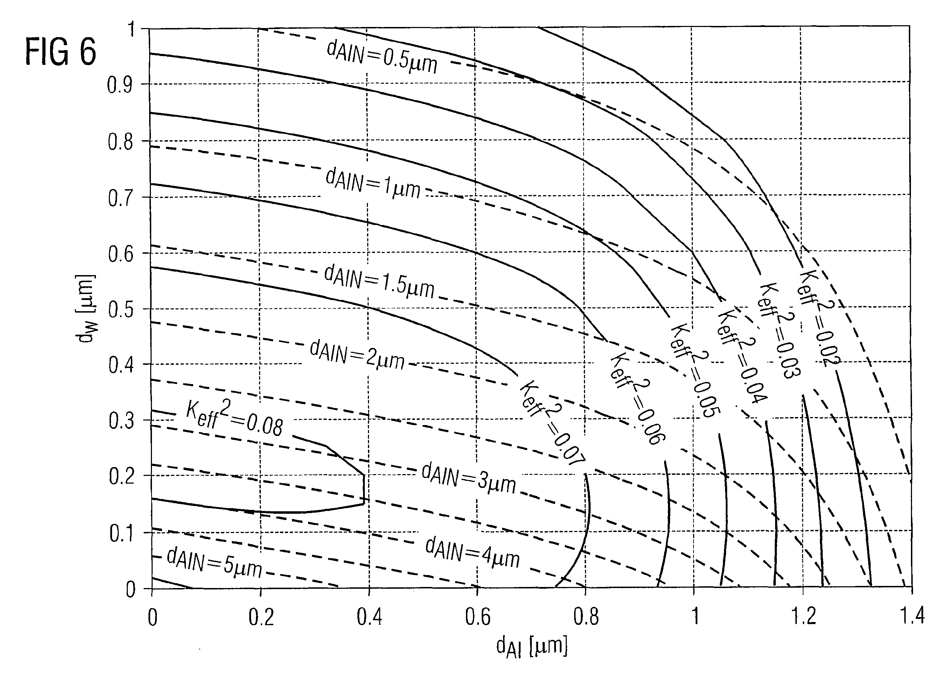

Im Ausführungsbeispiel ist ein dritter Resonator vorgesehen, der eine Schichtenfolge zum ineinander Umwandeln von akustischen Wellen und elektrischen Spannungsänderungen aufweist. Die Schichtenfolge umfaßt eine erste Elektrode E1 aus Aluminium, darüber eine erste Verdichtungsschicht V1 aus Wolfram, darüber eine piezoelektrische Schicht P aus AlN, darüber eine zweite Verdichtungsschicht V2 aus Wolfram und darüber eine zweite Elektrode E2 aus Aluminium. Die Streßverteilung bei Resonanz entspricht fast der des zweiten Resonators (siehe Figur 5). Der Verdichtungseffekt ist also auch noch vorhanden, wenn der zweite Resonator mit weiteren Schichten (hier Aluminium) versehen wird. Obwohl die akustische Welle im Aluminium einen geringen Gradienten hat, verdichtet das Wolfram den akustischen Streß (und somit die akustische Energie) in der piezoelektrischen Schicht. Das Wolfram dient somit als "akustische Verdichtungsschicht".

Die Resonatoren der zwei Vergleichsbeispiele und des Ausführungsbeispiels sind so ausgelegt, daß sie dieselbe Resonanzfrequenz und etwa den jeweils möglichen optimalen effektiven Koppelkoeffizienten aufweisen.

Durch die Verdichtungsschicht wird erreicht, daß das sich in der piezoelektrischen Schicht ausbildende Streßfeld vergleichsweise homogen ist, um eine gute Kopplung zwischen elektrischem und Streßfeld zu erreichen. Dies trägt zu einem höheren Koppelkoeffizienten bei. Auf die Verdichtungsschicht entfallen dagegen Bereiche geringeren Stresses, die, wenn sie in der Piezoschicht liegen würden, vergleichsweise wenig zur Kopplung beitragen würden. Durch die "Verdichtung" des Streßfeldes kann der Resonator bei gleichbleibender Resonanzfrequenz insgesamt dünner ausgebildet werden.

Mit Hilfe von Figur 6 läßt sich ein Resonator mit gewünschten Randbedingungen herstellen: Als Beispiel soll ein Resonator einen Koppelkoeffizienten >0,06 haben, und zur Reduktion der Serienwiderstände mindestens 200nm dicke Al-Elektroden haben. Folgt man der Koppelkoeffizient zum Quadrat k_{eff}²=0,06 - Linie bis zu jenem Punkt, bei dem die Dicke der Al-Elektroden d_{A1}=0,2*µ*m ist, so ergibt sich eine Dicke der Wolfram-Verdichtungsschichten von ca. 700nm und eine Dicke der piezoelektrischen Schicht von etwa 1,2µm. Ferner ist erkennbar, daß bei Verdickung der Al-Elektroden auf 600nm und Reduktion der Wolfram-Verdichtungsschichten auf 650nm sowohl die Dicke der piezoelektrischen Schicht als auch der Koppelkoeffizient näherungsweise konstant bleiben, der Serienwiderstand jedoch noch einmal erheblich reduziert werden kann. Als Vergleich: Ein äquivalenter Resonator mit A1-Elektroden ohne Verdichtungsschichten hätte eine Dicke der Al-Elektroden von ca. 900nm und eine Dicke der piezoelektrischen Schicht von ca. 3,5µm. Ein impedanzangepaßter Resonator wäre somit fast drei mal größer und bräuchte die 9-fache Menge an Aluminiumnitrid.

Nachfolgend sind akustische Impedanzen von einigen Materialen aufgelistet.

| Material | akustische Impedanz in 10⁶ Kg/m²s |
|---|---|
| A1 | 17,3 |
| W | 101 |
| AlN | 34,0 |
| Mo | 63,1 |
| Ir | 98 |
| Pt | 69,7 |
| Ta | 65,3 |
| TiW | 64,2 |
| Cu | 40,6 |
| Au | 62,5 |
| WSi | 90 |
| Cr | 47,4 |
| Al₂O₃ | 44,3 |
| SiN | 36,2 |
| Ta₂O₅ | 38 |
| ZnO | 36 |
| PZT | 17,3 |
| Ag | 17,2 |

### Bezugszeichenliste

- E1, E2, E1', E2', E1", E2": Elektrode
- P, P', P": piezoelektrische Schicht
- V1, V2: Verdichtungsschicht

## Patentansprüche

1. Akustischer Resonator
mit einer ersten Elektrode (E1), einer zweiten Elektrode (E2) und einer dazwischen angeordneten piezoelektrischen Schicht (P), wobei
zwischen der ersten Elektrode (E1) und der piezoelektrischen Schicht (P) eine erste akustische Verdichtungsschicht (V1) angeordnet ist, die eine höhere akustische Impedanz aufweist als die erste Elektrode (E1),
**dadurch gekennzeichnet, daß**
das Verhältnis der akustischen Impedanz der ersten akustischen Verdichtungsschicht (V1) zur akustischen Impedanz der piezoelektrischen Schicht (P) größer als 2 ist.

2. Akustischer Resonator nach Anspruch 1,
bei dem das Material der ersten Verdichtungsschicht (V1) so gewählt wird, daß das Verhältnis der akustischen Impedanz der ersten Verdichtungsschicht (V1) zur akustischen Impedanz der piezoelektrischen Schicht (P) möglichst groß ist.

3. Akustischer Resonator nach einem der Ansprüche 1 bis 2,
bei dem die erste Verdichtungsschicht (V1) im wesentlichen aus W, Mo, Ir, Pt, Ta, TiW, TiN, Au, WSi, Cr, Al₂O₃, SiN, Ta₂O₅ oder Zirkon-Oxid besteht.

4. Akustischer Resonator nach einem der Ansprüche 2 oder 3,
bei dem das Material der ersten Elektrode (E1) so gewählt wird, daß das Verhältnis der akustischen Impedanz der ersten Elektrode (E1) zur akustischen Impedanz der ersten Verdichtungsschicht (V1) möglichst klein ist.

5. Akustischer Resonator nach einem der Ansprüche 1 bis 4,
bei dem die erste Elektrode (E1) eine höhere elektrische Leitfähigkeit aufweist als die erste Verdichtungsschicht (V1).

6. Akustischer Resonator nach einem der Ansprüche 1 bis 5,
bei dem die erste Elektrode (E1) und/oder die zweite Elektrode (E2) im wesentlichen aus Aluminium, Titan, Silber oder Kupfer bestehen.

7. Akustischer Resonator nach einem der Ansprüche 1 bis 6,
bei dem zwischen der zweiten Elektrode(E2) und der piezoelektrischen Schicht (P) eine der ersten Verdichtungsschicht (V1) entsprechende zweite akustische Verdichtungsschicht (V2) angeordnet ist, die eine höhere akustische Impedanz aufweist als die zweite Elektrode (E2).

8. Akustischer Resonator nach einem der Ansprüche 1 bis 6, bei dem die erste Verdichtungsschicht (V1) im wesentlichen aus einem leitfähigen Material besteht.

9. Akustischer Resonator nach Anspruch 7 oder 8, bei dem die zweite Verdichtungsschicht (V2) im wesentlichen aus einem leitfähigen Material besteht.

## Claims

1. An acoustic resonator with a first electrode (E1), a second electrode (E2) and a piezoelectric layer (P) arranged in between, **characterized in that** a first acoustic compression layer (V1), which has a higher acoustic impedance than the first electrode (E1), is arranged between the first electrode (E1) and the piezoelectric layer (P).

2. The acoustic resonator as claimed in claim 1, in which the material of the first compression layer (V1) is chosen such that the ratio of the acoustic impedance of the first compression layer (V1) to the acoustic impedance of the piezoelectric layer (P) is as great as possible.

3. The acoustic resonator as claimed in one of claims 1 to 2, in which the first compression layer (V1) consists substantially of W, Mo, Ir, Pt, Ta, TiW, TiN, Au, WSi, Cr, Al₂O₃, SiN, Ta₂O₅ or zirconium oxide.

4. The acoustic resonator as claimed in one of claims 2 or 3, in which the material of the first electrode (E1) is chosen such that the ratio of the acoustic impedance of the first electrode (E1) to the acoustic impedance of the first compression layer (V1) is as small as possible.

5. The acoustic resonator as claimed in one of claims 1 to 4, in which the first electrode (E1) has a higher electrical conductivity than the first compression layer (V1).

6. The acoustic resonator as claimed in one of claims 1 to 5, in which the first electrode (E1) and/or the second electrode (E2) consist(s) substantially of aluminium, titanium, silver or copper.

7. The acoustic resonator as claimed in one of claims 1 to 6, in which a second acoustic compression layer (V2), which corresponds to the first compression layer (V1) and has a higher acoustic impedance than the second electrode (E2), is arranged between the second electrode (E2) and the piezoelectric layer (P).

8. The acoustic resonator as claimed in one of claims 1 to 6, in which the first compression layer (V1) consists substantially of a conductive material.

9. The acoustic resonator as claimed in claim 7 or 8, in which the second compression layer (V2) consists substantially of a conductive material.

## Revendications

1. Résonateur acoustique
comprenant une première électrode (E1), une deuxième électrode (E2) et une couche (P) piézoélectrique interposée entre elles, dans lequel
il est disposé entre la première électrode (E1) et la couche (P) piézoélectrique une première couche (V1) de condensation acoustique, qui a une impédance acoustique plus grande que la première électrode (E1),
**caractérisé en ce que**
le rapport de l'impédance acoustique de la première couche (V1) de condensation acoustique à l'impédance acoustique de la couche (P) piézoélectrique est supérieur à 2.

2. Résonateur acoustique suivant la revendication 1,
dans lequel le matériau de la première couche (V1) de condensation est choisi de façon à ce que le rapport de l'impédance acoustique de la première couche (V1) de condensation à l'impédance acoustique de la couche (P) piézoélectrique soit aussi grand que possible.

3. Résonateur acoustique suivant l'une des revendications 1 à 2, dans lequel la première couche (V1) de condensation est essentiellement en W, Mo, Ir, Pt, Ta, TiW, TiN, Au, WSi, Cr, Al₂O₃, SiN, Ta₂O₅ ou en oxyde de zirconium.

4. Résonateur acoustique suivant l'une des revendications 2 ou 3, dans lequel le matériau de la première électrode (E1) est choisi de façon à ce que le rapport de l'impédance acoustique de la première électrode (E1) à l'impédance acoustique de la première couche (V1) de condensation soit aussi petit que possible.

5. Résonateur acoustique suivant l'une des revendications 1 à 4, dans lequel la première électrode (E1) a une conductivité électrique plus grande que la première couche (V1) de condensation.

6. Résonateur acoustique suivant l'une des revendications 1 à 5, dans lequel la première électrode (E1) et/ou la deuxième électrode (E2) sont essentiellement en aluminium, titane, argent ou cuivre.

7. Résonateur acoustique suivant l'une des revendications 1 à 6, dans lequel il est disposé entre la deuxième électrode (E2) et la couche (P) piézoélectrique une deuxième couche (V2) de condensation acoustique correspondant à la première couche (V1) de condensation et ayant une impédance acoustique plus grande que celle de la deuxième électrode (E2).

8. Résonateur acoustique suivant l'une des revendications 1 à 6, dans lequel la première couche (V1) de condensation est essentiellement en un matériau conducteur.

9. Résonateur acoustique suivant la revendication 7 ou 8, dans lequel la deuxième couche (V2) de condensation est essentiellement en un matériau conducteur.
